# EUROPEAN PATENT APPLICATION

(11) **EP 4 386 480 A1**
(43) Date of publication of application: **19.06.2024**
(21) Application number: 22213693.9
(22) Date of filing: 15.12.2022
(51) Int. Cl.: G03F 7/00

(54) **FLUSHING SYSTEM AND METHOD FOR A LITHOGRAPHIC APPARATUS**

(71) Applicant: ASML Netherlands B.V., 5500 AH Veldhoven (NL)
(72) Inventor: VAN DEN AKKER, Emericus, Antoon, Theodorus, 5500 AH Veldhoven (NL); DANNENBERG, Johan, Frederik, 5500 AH Veldhoven (NL); LINTHORST, Mart, Willem, 5500 AH Veldhoven (NL); KALKMAN, Ivo, Michel, 5500 AH Veldhoven (NL); HAZARI, Syed, Aaquib, 5500 AH Veldhoven (NL)
(74) Representative: ASML Netherlands B.V.

(57) **Abstract**

There is provided a flushing system for a lithographic apparatus, said flushing system including a gas outlet configured to choke a flow of gas passing through the gas outlet at a predetermined rate. Also provided is a method of flushing a lithographic apparatus, the method including providing a flow of gas through the lithographic apparatus and operating a gas outlet from the lithographic apparatus such that the flow of gas is choked through the gas outlet.

## Description

### FIELD

The present disclosure relates to a flushing system for a lithographic apparatus, particularly an EUV lithographic apparatus. The present disclosure also relates to a method of flushing a lithographic apparatus, a lithographic apparatus including such a flushing system, and the use of such a flushing system, lithographic apparatus, or flushing method in a lithographic process or apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

A lithographic apparatus includes a patterning device (e.g. a mask or reticle). Radiation is provided through or reflected off the patterning device to form an image on a substrate. A membrane assembly, also referred to as a pellicle, may be provided to protect the patterning device from airborne particles and other forms of contamination. Contamination on the surface of the patterning device can cause manufacturing defects on the substrate.

Due to the extremely high precision required of a lithographic apparatus to efficiently form an image on a substrate, it is important that the interior of the lithographic apparatus is kept clean. In use over time, contaminants can build up within the apparatus and so it is necessary to periodically clean the interior of the lithographic apparatus. One way in which this is done is by providing a flow of gas through the apparatus. The flow of gas is able to remove contaminants from the interior of the lithographic apparatus, thereby preventing such contaminants from adversely affecting the operation of the lithographic apparatus.

Despite flushing being a critically important requirement, the flushing process takes time to complete and during the time, the lithographic apparatus is unable to operate and image wafers. This therefore reduces the uptime of the lithographic apparatus. It is therefore desirable to reduce the downtime required to flush a lithographic apparatus. In addition, it is important that the flushing process is consistent and predictable, so that the effectiveness of the flushing can be assured.

The present invention has been devised in an attempt to address at least some of the problems identified above.

### SUMMARY OF THE INVENTION

According to a first aspect of the present disclosure, there is provided a flushing system for a lithographic apparatus, said flushing system including a gas outlet configured to choke a flow of gas passing through the gas outlet at a predetermined rate.

When flushing a lithographic apparatus, the gas outlet is attached to a pump, such as a turbomolecular pump, via a so-called customer interface. Gas is flowed through the lithographic apparatus to remove contaminants. The gas flows out of the gas outlet and is taken away by the pump in fluid communication with the customer interface. The pump is separate to the lithographic apparatus and the quality of the vacuum provided by such a pump varies location by location. It is necessary to ensure that the flow of gas within the lithographic apparatus is suitable to prevent deposition of contaminants on important optical elements, such as mirrors, the reticle, or the wafer stage. As such, it is useful for the flow within the lithographic apparatus is carefully controlled. The present disclosure allows for the gas flow within the lithographic apparatus to be independent of the quality of the customer's pump. This is achieved by configuring the apparatus such that the flow of gas is choked. When a flow of gas is choked, the rate of the flow of the gas is dependent on the properties of the gas and the outlet through which it is flowing. The flow of a gas can therefore be made independent of the quality of the customer's pump. For example, without a choked flow, a weaker pump would result in a smaller flow rate of gas out of the lithographic and a more powerful pump would result in a greater flow of gas. As such, without a choked flow, the flushing process needs to be selected to accommodate all specifications of pump and to be conservative such that even a pump which meets only the minimum requirements is able to effectively flush the lithographic apparatus. As such, the flushing process is not optimised. Since the present disclosure decouples the flow rate from the quality of the customer's pump, it is possible to optimise the flushing process and for the flushing to be more consistent across all lithographic apparatuses. Furthermore, due to the need to accommodate a large range of customer pumps, the flushing rate requirements are strict. In addition, a large part of the time taking for the flushing process involves ramping up and down mass flow controllers since these are slow to operate. The additional time taken for the mass flow controllers to ramp up and ramp down causes the flushing process to take longer and thereby increase downtime of the lithographic apparatus.

The system may include a controller configured to control the gas outlet. The gas outlet may be variable such that the desired choking can be controlled. For example, in some cases, it may be necessary for the flow to not be choked and, in such cases, the outlet can be controlled to allow a flow of gas to exit the outlet without being choked. Similarly, where the gas flow is not constant, the controller may control the outlet to accommodate different rates of gas flow whilst still providing a choked flow at the outlet. The controller may, for example, control the degree to which the outlet is opened to control choking.

The flushing system may include one or more pilot valves configured to selectively open and close. By selectively opening and closing one or more pilot valves, it is possible to cause pressure fluctuations in the flow of gas. A pilot valve may be configured to open at a predetermined pressure. A pilot valve may be configured to be opened and closed by a solenoid. The opening and closing of the valve may be controlled by the controller. The frequency and/or duty cycle of the pilot valve can be predetermined depending on the desired flushing parameters. Pressure fluctuations allows more effective dislodgement of contaminants and can therefore speed up the flushing process and/or make the flushing process more thorough. Any suitable pilot valve may be used. Since the flow of gas is choked at the gas outlet, the pilot valves can be operated more rapidly than the mass flow controllers that are currently used. This further allows the flushing process to be more readily controlled.

The flushing system may be configured to provide a flow rate of gas of from around 20 normal litres per minute (nlm) to around 700 nlm, optionally around 100 nlm, around 200 nlm, around 300 nlm, around 400 nlm, around 500 nlm, or around 600 nlm.

The flushing system may be configured to provide a pressure within the lithographic apparatus of up to 2000 Pa, up to 1500 Pa, up to 1000 Pa, up to 500 Pa, up to 250 Pa, or up to 100 Pa. The pressure within the lithographic apparatus needs to be controlled to avoid damage to components, such as a pellicle or dynamic gas lock membrane, therein. By having a choked flow at the outlet, it is more readily possible to control the pressure within the apparatus during flushing since the flow rate of gas out of the apparatus is choked at a predetermined level.

The flushing system may be configured to operate at a constant gas flow rate. By providing a constant gas flow rate, it is not necessary to wait for the lines to be filled and to discharge gas, which is time consuming.

According to a second aspect of the present disclosure, there is provided a method of flushing a lithographic apparatus, the method including providing a flow of gas through the lithographic apparatus and operating a gas outlet from the lithographic apparatus such that the flow of gas is choked through the gas outlet.

As described in respect of the first aspect of the present disclosure, a choked outlet for the gas flow allows for the flow within the lithographic apparatus to be decoupled from the quality of the pump being used to withdraw the gas from the lithographic apparatus.

The method may include providing a flow of gas of from around 20 nlm to around 700 nlm, optionally around 100 nlm, around 200 nlm, around 300 nlm, around 400 nlm, around 500 nlm, or around 600 nlm through the lithographic apparatus.

The method may include providing the flow of gas at a constant rate. The provision of gas at a constant rate reduces the need for controllers and makes the flushing process more consistent.

The method may include causing pressure pulses in the flow of gas. The method may include causing the pressure pulses in the flow of gas by opening and closing one or more pilot valves. Since the valves do not need to control the flow rate of gas precisely, rather they just need to vary the amount allowed to flow out of the lithographic apparatus to alter the pressure therein, they can be operated more rapidly than previous systems which used mass flow controllers. Furthermore, the better control allows less flow in the system to be used, which reduces the requirements for the accessories required to control the flow, thereby saving space and costs.

According to a third aspect of the present disclosure, there is provided a lithographic apparatus including the flushing system according to the first aspect of the present disclosure.

According to a fourth aspect of the present disclosure, there is provided the use of a flushing system in accordance with the first aspect of the present disclosure, a lithographic apparatus according to the third aspect of the present disclosure, or a method according to the second aspect of the present disclosure in a lithographic method or apparatus.

It will be appreciated that features described in respect of one embodiment may be combined with any features described in respect of another embodiment and all such combinations are expressly considered and disclosed herein.

### BRIEF DESCRIPTION OF THE DRAWINGS

Embodiments of the invention will now be described, by way of example only, with reference to the accompanying schematic drawing in which corresponding reference symbols indicate corresponding parts, and in which:
Figure 1 depicts a lithographic apparatus according to an embodiment of the disclosure;
Figure 2 depicts a schematic of a system according to an aspect of the present disclosure; and
Figure 3 depicts an exemplary flushing cycle.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements.

### DETAILED DESCRIPTION

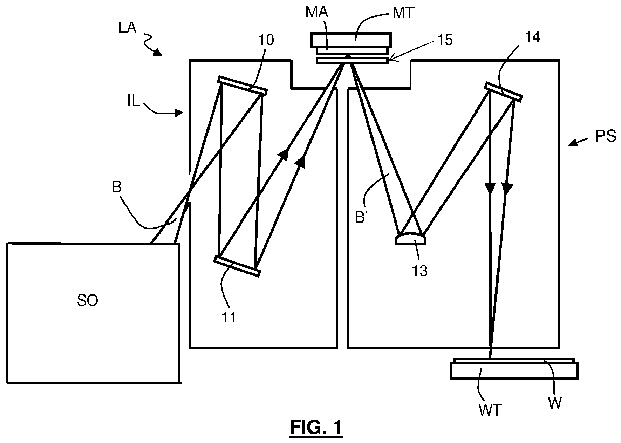

Figure 1 shows a lithographic system according to the present invention. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W. In this embodiment, a pellicle 15 is depicted in the path of the radiation and protecting the patterning device MA. It will be appreciated that the pellicle 15 may be located in any required position and may be used to protect any of the mirrors in the lithographic apparatus.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser, which may for example be a CO₂ laser, is arranged to deposit energy via a laser beam into a fuel, such as tin (Sn) which is provided from a fuel emitter. Although tin is referred to in the following description, any suitable fuel may be used. The fuel may for example be in liquid form, and may for example be a metal or alloy. The fuel emitter may comprise a nozzle configured to direct tin, e.g. in the form of droplets, along a trajectory towards a plasma formation region. The laser beam is incident upon the tin at the plasma formation region. The deposition of laser energy into the tin creates a plasma at the plasma formation region. Radiation, including EUV radiation, is emitted from the plasma during de-excitation and recombination of ions of the plasma.

The EUV radiation is collected and focused by a near normal incidence radiation collector (sometimes referred to more generally as a normal incidence radiation collector). The collector may have a multilayer structure which is arranged to reflect EUV radiation (e.g. EUV radiation having a desired wavelength such as 13.5 nm). The collector may have an elliptical configuration, having two ellipse focal points. A first focal point may be at the plasma formation region, and a second focal point may be at an intermediate focus, as discussed below.

The laser may be separated from the radiation source SO. Where this is the case, the laser beam may be passed from the laser to the radiation source SO with the aid of a beam delivery system (not shown) comprising, for example, suitable directing mirrors and/or a beam expander, and/or other optics. The laser and the radiation source SO may together be considered to be a radiation system.

Radiation that is reflected by the collector forms a radiation beam B. The radiation beam B is focused at a point to form an image of the plasma formation region, which acts as a virtual radiation source for the illumination system IL. The point at which the radiation beam B is focused may be referred to as the intermediate focus. The radiation source SO is arranged such that the intermediate focus is located at or near to an opening in an enclosing structure of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors 13, 14 which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

In an embodiment the membrane assembly 15 is a pellicle for the patterning device MA for EUV lithography. The membrane assembly 15 can be used for a dynamic gas lock or for a pellicle or for another purpose. In an embodiment the membrane assembly 15 comprises a membrane formed from at least one membrane layer having an emissivity of 0.3 or more. In order to ensure maximized EUV transmission and minimized impact on imaging performance it is preferred that the membrane is only supported at the border.

If the patterning device MA is left unprotected, the contamination can require the patterning device MA to be cleaned or discarded. Cleaning the patterning device MA interrupts valuable manufacturing time and discarding the patterning device MA is costly. Replacing the patterning device MA also interrupts valuable manufacturing time. The system of the present disclosure allows for rapid, consistent and effective cleaning of the interior of the lithographic apparatus.

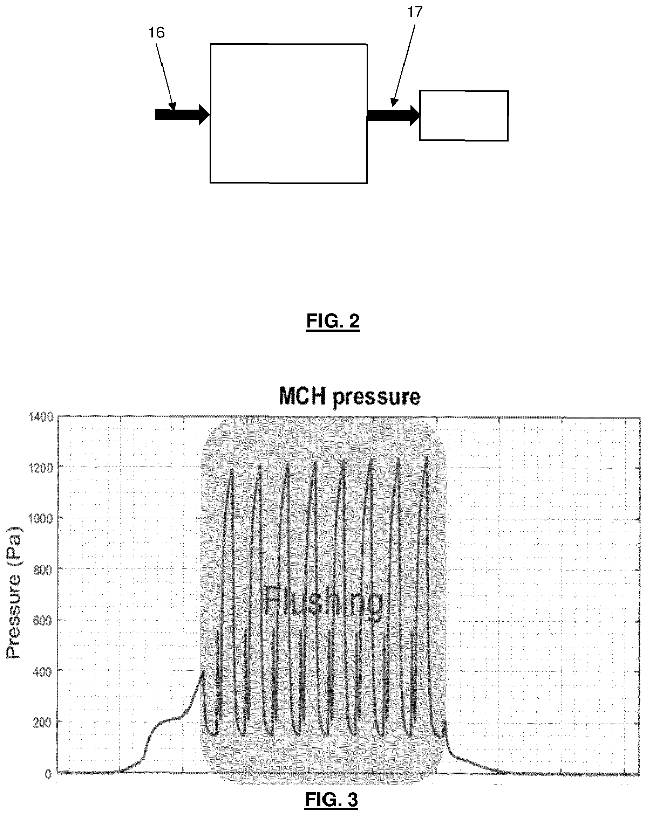

Figure 2 is a schematic depiction of a lithographic apparatus including the flushing system according to the present disclosure. There is provided an inlet flow of gas 16 into the lithographic apparatus LA. Also provided is an outlet 17 through which the gas may exit the lithographic apparatus. A pump 18, which does not form part of the lithographic apparatus and is provided at a customer's location for attaching to the lithographic apparatus, is in fluid connection with the outlet 17 and serves to remove gas from the lithographic apparatus. Outlet 17 is configured such that in the operating parameters of the lithographic apparatus during flushing, the flow of gas is choked. As described, a choked flow decouples gas flow within the lithographic apparatus from the specific pump to which the lithographic apparatus is attached in use. The lithographic apparatus LA may include one or more pilot valves (not shown) configured to open and close to create variances in pressure within the lithographic apparatus to assist with removal of contaminants.

Figure 3 depicts an exemplary flushing cycle. As can be seen, the pressure within the lithographic apparatus is cycled in order to dislodge contaminants and remove them from the lithographic apparatus. During each cycle, the flow of gas may be constant or may be altered. Alternatively or additionally, pressure pulses can be introduced by the opening and closing of one or more pilot valves. Since the outlet flow is choked and the pressure is decoupled from the pressure at the customer interface, there is more freedom to select the pressure so the flushing procedure can be optimised making flushing more effective, leading to cleaner apparatuses. As such, in addition to each cycle being quicker, it is possible to use fewer cycles since each cycle is more effective at cleaning, thereby further saving additional time.

Table 1 shows some exemplary operating parameters for a system according to the present disclosure.

| Table 1 | Flow rate during high peak of flushing | First Valve | Second Valve |
|---|---|---|---|
| Prior Art | ∼500 nlm | Unchoked | Closed |
| Option 1 | ∼300 nlm | Choked | Closed |
| Option 2 | ∼200 nlm | Closed | Choked |
| Option 3 | ∼200-300 nlm | Pilot valve used to vary pressure | |

The exemplary system includes two valves which may be controlled by a controller. In the first option, the flow rate is 300 nlm, which may be divided into two separate flows, a first flow for cleaning of around 200 nlm and a second flow for flow stabilisation of around 100 nlm. A first valve may be opened sufficiently to provide choked flow and a second valve, which is more restrictive to gas flow when open, may be closed. In a second option, a lower gas flow rate of 200 nlm may be used. In this option, the first valve may be closed, and the second smaller valve may be opened sufficiently to provide choked flow. A smaller valve may be used in view of the lower flow rate. In a third option, a pilot valve may be used to provide pressure pulses, and the choked flow may be provided according to either of the first or second options. In the third option, one or more mass flow controllers can remain at a fixed flow rate such that no time is spent on filling and releasing gas in lines repeatedly.

While specific embodiments of the invention have been described above, it will be appreciated that the invention may be practiced otherwise than as described.

The descriptions above are intended to be illustrative, not limiting. Thus it will be apparent to one skilled in the art that modifications may be made to the invention as described without departing from the scope of the claims set out below.

## Claims

1. A flushing system for a lithographic apparatus, said flushing system including a gas outlet configured to choke a flow of gas passing through the gas outlet at a predetermined rate.

2. The flushing system according to claim 1, wherein the system includes a controller configured to control the gas outlet.

3. The flushing system according to any preceding claim, wherein the flushing system includes one or more pilot valves configured to selectively open and close.

4. The flushing system according to any preceding claim, wherein the flushing system is configured to provide a flow rate of gas of from around 20 nlm to around 700 nlm, optionally around 100 nlm, around 200 nlm, around 300 nlm, around 400 nlm, around 500 nlm, or around 600 nlm.

5. The flushing system according to any preceding claim, wherein the flushing system is configured to provide a pressure within the lithographic apparatus of up to 2000 Pa, up to 1500 Pa, up to 1000 Pa, up to 500 Pa, up to 250 Pa, or up to 100 Pa.

6. The flushing system according to any preceding claim, wherein the flushing system is configured to operate at a constant gas flow rate.

7. A method of flushing a lithographic apparatus, the method including providing a flow of gas through the lithographic apparatus and operating a gas outlet from the lithographic apparatus such that the flow of gas is choked through the gas outlet.

8. The method of flushing a lithographic apparatus according to claim 7, wherein the method includes providing a flow of gas of from around 20 nlm to around 700 nlm, optionally around 100 nlm, around 200 nlm, around 300 nlm, around 400 nlm, around 500 nlm, or around 600 nlm through the lithographic apparatus.

9. The method of flushing a lithographic apparatus according to claim 7 or claim 8, wherein the method includes providing a flow of gas at a constant rate.

10. The method of flushing a lithographic apparatus according to any of claims 7 to 9, wherein the method includes causing pressure pulses in the flow of gas.

11. The method of flushing a lithographic apparatus according to claim 10, wherein the pressure pulses are caused by opening and closing of one or more pilot valves.

12. A lithographic apparatus including the flushing system according to any of claims 1 to 6.

13. Use of a flushing system according to any of claims 1 to 6, a lithographic apparatus according to claim 12, or a method according to any of claims 7 to 11 in a lithographic method or apparatus.
